(19) **Europäisches Patentamt European Patent Office Office européen des brevets**

(11) **EP 3 509 205 B1**

(12) **EUROPEAN PATENT SPECIFICATION**

(45) Date of publication and mention of the grant of the patent:
**17.11.2021 Bulletin 2021/46**

(51) Int Cl.:
**H02M 7/493** *(2007.01)*  **H02J 3/38** *(2006.01)*
**H02J 1/10** *(2006.01)*  **H02S 50/10** *(2014.01)*
**H02S 40/32** *(2014.01)*  **G01R 31/40** *(2020.01)*

(21) Application number: **18150418.4**

(22) Date of filing: **05.01.2018**

(54) **METHOD FOR DETECTING THE INPUT CHANNEL CONFIGURATION OF A MULTI-CHANNEL INVERTER**

VERFAHREN ZUR ERKENNUNG DER EINGANGSKANALKONFIGURATION EINES MEHRKANALIGEN WECHSELRICHTERS

PROCÉDÉ PERMETTANT DE DÉTECTER LA CONFIGURATION DE CANAL D'ENTRÉE D'UN INVERSEUR MULTICANAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**10.07.2019 Bulletin 2019/28**

(73) Proprietor: **ABB Schweiz AG**
**5400 Baden (CH)**

(72) Inventors:
• **Scaletti, Silvio**
**I-52041 Civitella in Val di Chiana (AR) (IT)**

• **Guerriero, Alessandro**
**I-66020 Paglieta (CH) (IT)**

(74) Representative: **De Bortoli, Eros et al**
**Zanoli & Giavarini S.p.A.**
**Via Melchiorre Gioia, 64**
**20125 Milano (IT)**

(56) References cited:
**US-A1- 2011 204 878    US-A1- 2015 076 911**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a method for detecting the input channel configuration of a multi-channel inverter.

As is known, a multi-channel inverter comprises an input section and an output section adapted to receive DC electric power from a DC electric system and provide AC electric power to an AC electric system, respectively.

As an example, in photovoltaic installations, a multi-channel inverter may comprise the input section electrically connected with a photovoltaic panel or a photovoltaic string and the output section electrically connected with an electric power distribution grid.

In a multi-channel inverter, the above-mentioned input section includes a plurality of input channels, each of which is electrically connected with a corresponding power converter (e.g. a DC/DC power converter) and, in operation, with a corresponding DC electric power source. In many applications, e.g. in photovoltaic plants, multi-channel inverters may have some input channels electrically connected in parallel with a same DC source and other input channels operating independently, i.e. singularly connected with a corresponding DC source. For this reason, during the commissioning phase, normally, the control unit of a multi-channel inverter has to be properly configured to take into account the physical connection status of the input channels and ensure a proper operation of the inverter.

In currently available installations, the above-mentioned configuration operation entails the intervention of specialized personnel.

As an example, in some cases, an operator can carry out such a configuration operation by manually setting a dip switch of the control unit of the inverter.

As a further example, in other cases, an operator can provide the control unit with configuration information indicative of the input channel configuration of the inverter through a HMI (e.g. a touch display) or by downloading a suitable configuration file.

As it is easy to understand, the need for carrying out the above-mentioned configuration operations entails a remarkable increase of the commission time and costs to put the photovoltaic inverter in condition to operate.

Nowadays, there is a relevant market demand for having multi-channel inverters that can be installed on the field with lowered (virtually null) commissioning time and costs.

In the state of the art, it is therefore quite felt the need for solutions overcoming or mitigating the above-illustrated drawbacks of the state of the art.

Methods for determining whether photovoltaic converters are connected in parallel or operated independently from each other based on input voltage comparisons are disclosed in US2015076911 and US2011204878.

The present invention intends to respond to this need by providing a method for detecting the input channel configuration of a multi-channel inverter, according to the following claim 1 and the related dependent claims.

In a general definition, the method, according to claim 1 of the invention, comprises the following steps:

a) selecting a reference input channel among said input channels;

b) controlling power converters electrically connected with the input channels so that an input current higher than a current threshold is set along said reference input channel and so that input currents lower than said current threshold are set along one or more remaining input channels different from said reference input channel;

c) acquiring detection data indicative of input voltages of said input channels following a selective current feeding of said input channels obtained by controlling said power converters in such a way that said input channels are fed with currents having selected profiles or different growth rates;

d) performing a comparison between the input voltages of said input channels based on said detection data, said comparison including calculating the voltage differences between the input voltages of said remaining input channels and the input voltage of said reference channel and comparing said voltage differences with predefined threshold values;

e) executing a determination procedure to determine a configuration status of said input channels based on a behavior of the input voltages of said remaining input channels with respect to the input voltage of said reference channel, the configuration status of each input channel being determined by checking whether the input voltages of said remaining input channels decrease as the input voltage of said reference input channel.

Preferably, said step b) of controlling said power converters comprises activating the power converter corresponding to said reference input channel and deactivating or maintaining deactivated the power converters corresponding to said remaining input channels.

According to an aspect of the invention, said step d) of performing a comparison between the input voltages of said input channels comprises checking whether the input voltages of said remaining input channels behave as the input voltage of said reference input channel. According to an aspect of the invention, said determination procedure comprises the following step:
e.1) if the input voltages of said remaining input channels do not decrease as the input voltage at said reference input channel, determining that said reference input channel is an independent input channel.

According to an aspect of the invention, said determination procedure further comprises the following steps:

> e.2) if there is a single remaining input channel, determining that said remaining input channel is an independent input channel; or
> e.3) if there is a plurality of remaining input channels, repeating said steps a), b), c), d), e) for said remaining input channels.

According to an aspect of the invention, said determination procedure comprises the following step:
e.4) if the input voltages of one or more first remaining input channels decrease as the input voltage at said reference input channel, determining that said reference input channel and said one or more first remaining input channels are parallel input channels.

According to an aspect of the invention, if the input voltages of one or more second remaining input channels, different from said first remaining input channels, do not decrease as the input voltage of said reference input channel said determination procedure comprises the following steps:

> e.5) if said second remaining channels include a single second remaining input channel, determining that said remaining input channel is an independent input channel; or
> e.6) if said second remaining channels include a plurality of second remaining input channels, repeating said steps a), b), c), d), e) for said second remaining input channels.

Preferably, the method, according to the invention, comprises the step f) of storing configuration information indicative of the configuration status determined for said input channels.

In a further aspect, the present invention relates to a multi-channel inverter, according to the following claim 9 and the related dependent claims.

Further features and advantages of the present invention will be apparent in the following description of non-limitative embodiments with reference to the figures in the accompanying drawings, in which:

- figure 1 shows a schematic block diagram of a photovoltaic inverter implementing the method according to the present invention;
- figure 2 shows a schematic block diagram describing the steps of method according to the present invention;
- figures 3A-3B show a schematic block diagram describing in details a determination procedure carried out by the method according to the present invention;
- figures 4-9 schematically illustrate some examples of implementation of the method, according to the invention, in a multi-channel inverter;

- figure 10 schematically illustrates an example of operational characteristic curve of a photovoltaic source.

Referring to the cited figures, the present invention relates to a method for detecting the input channel configuration of a multi-channel inverter 100.

The multi-channel inverter 100 is particularly adapted for use in photovoltaic installations and, in the following, it will be described with particular reference to these applications without intending to limit the scope of the invention. In fact, the multi-channels inverter 100 may be conveniently used in low-voltage installations of different types, such as those including batteries, capacitor banks, and the like, as DC electric power sources.

For the sake of clarity, it is specified that the term "low voltage" refers to operating voltages lower than 1 kV AC and 1.5 kV DC.

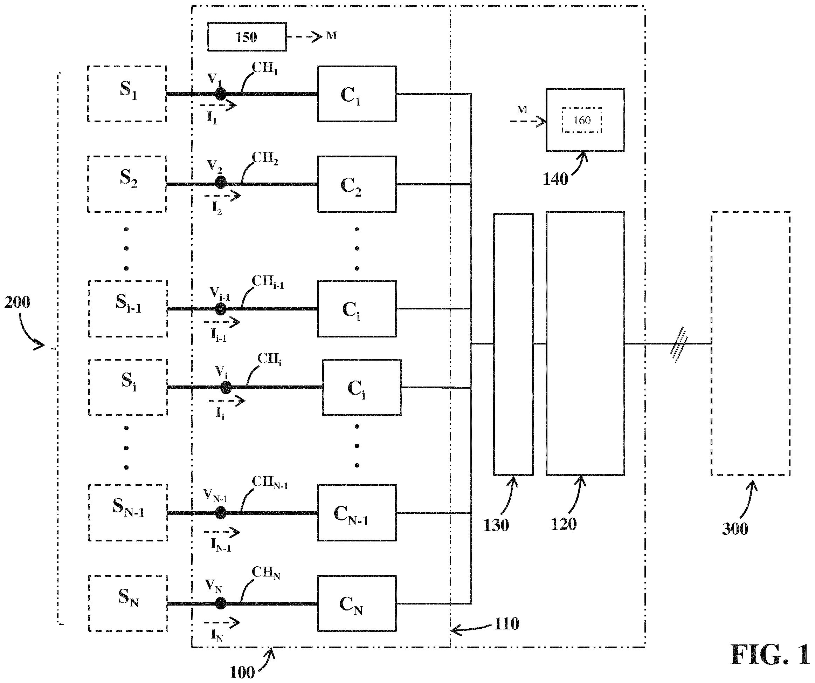

With particular reference to figure 1, the inverter 100 comprises an input section 110 that, in operation, is intended to be electrically connected with a DC electric system 200 adapted to provide DC electric power in output.

The input section 110 comprises a plurality of input channels $CH_1$, $CH_2$, ..., $CH_{i-1}$, $CH_i$, ..., $CH_{N-1}$, $CH_N$, each of which is electrically connected with a DC electric power source $S_1$, $S_2$, ..., $S_{i-1}$, $S_i$, ..., $S_{N-1}$, $S_N$ when the inverter 100 is installed on the field.

The DC sources $S_1$, ..., $S_N$ may include photovoltaic panels or strings, batteries, capacitor banks or other electric and/or electronic apparatuses providing DC electric power in output (e.g. photovoltaic panel optimizing apparatuses).

The inverter 100 may be operatively coupled to DC sources $S_1$,..., $S_N$ of a same type (e.g. all including photovoltaic panels or strings) or of different types (e.g. including photovoltaic panels or strings and/or batteries and/or capacitor banks and/or other apparatuses as illustrated above).

The input section 110 comprises a plurality of power converters $C_1$, $C_2$, ..., $C_{i-1}$, $C_i$, ..., $C_{N-1}$, $C_N$, each of which may comprise, for example, one or more DC/DC converters. Conveniently, each power converter $C_1$,..., $C_N$ is electrically connected with a corresponding input channel $CH_1$, ..., $CH_N$.

The inverter 100 further comprises an output section 120 intended, in operation, to be electrically connected with an AC electric system 300, preferably an electric power distribution grid, e.g. of single-phase or multi-phase type.

The output section 120 may comprise, for example, one or more further power converters, e.g. one or more AC/AC converters.

Conveniently, the inverter 100 may comprise a coupling section 130 to electrically connect the input section 110 and the output section 120.

The coupling section 130 may comprise, for example, one or more capacitor banks (DC-Link stage) electrically connected in parallel between the output terminals of the input section 110 and the input terminals of the output section 120.

Conveniently, the inverter 100 comprises control means 140 to control its functionalities, in particular the operation of the input and output sections 110, 120.

In an industrial implementation of the inverter 100, the control means 140 may comprise one or more control units arranged on-board the inverter.

Preferably, the control means 140 include data processing resources 160 to carry out their functionalities.

If industrially implemented in analog manner, the data processing resources 160 may comprise suitably arranged electronic circuits of analog type.

If industrially implemented in a digital manner, the data processing resources 160 may comprise one computerized units (e.g. DSPs or microprocessors) configured to execute sets of software instructions stored or storable in a medium.

As a further alternative, the data processing resources 160 may comprise integrated circuits or other electronic arrangements (e.g. FPGAs, SoC, and the like) capable of processing analog and/or digital signals.

Preferably, the control means 140 are configured to control the power converters $C_1, ..., C_N$ of the input section 110 operatively associated to the input channels $CH_1, ..., CH_N$.

As an example, the control means 140 are conveniently configured to activate or deactivate the above-mentioned power converters and/or operate them according to given working functions.

It is important to put in clear evidence that the control means 140 can control the input currents $I_1, I_2, ..., I_{i-1}, I_i, ..., I_{N-1}, I_N$ flowing along each input channel $CH_1, ..., CH_N$ by suitably controlling the corresponding power converter $C_1, ..., C_N$.

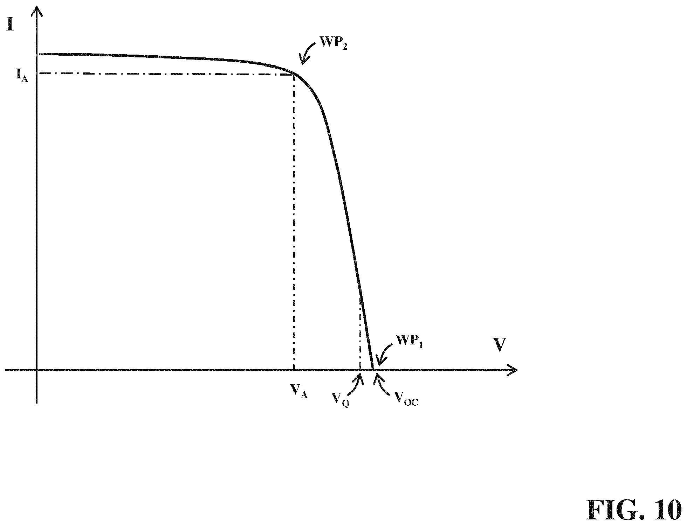

Supposing that the inverter 100 is operatively coupled to photovoltaic sources $S_1, ..., S_N$ at the input channels $CH_1, ..., CH_N$, when a generic input channel $CH_i$ of the inverter 100 is electrically connected with a photovoltaic source $S_i$, the input voltage $V_i$ of said input channel typically follows the operational characteristic curve of said photovoltaic source, an example of which is schematically shown in figure 10.

As it is possible to observe, said operational characteristic curve has a monotone trend, which means that, in operation, a single voltage value at said input channel univocally corresponds to a given current value flowing along said input channel.

When no input current flows ($I_i = 0$ a part from said leakage currents) along said generic input channel $CH_i$, the photovoltaic source $S_i$ operates at the working point $WP_1$. In this case, the input voltage $V_i$ of the input channel $CH_i$ is $V_i = V_{OC}$, where $V_{OC}$ is a no-load voltage value. When an input current $I_i$ flows along said generic input channel $CH_i$, the photovoltaic source $S_i$ operates at a different working point $WP_2$. In this case, the input voltage $V_i$ of the input channel $CH_i$ decreases and takes a value $V_i = V_A$, where $V_A$ is a unique voltage value corresponding to the working point $WP_2$.

In operation, the position of the working point $WP_2$ (and therefore the corresponding voltage value $V_A$) depends on the current value $I_A$ imposed by the power converter $C_i$ operatively associated to the generic input channel $CH_i$.

The value $I_A$ of the current flowing along the input channel $CH_i$ depends, in turn, on the kind of regulation, for example a MPPT (Maximum Power Point Tracking) regulation, constant power regulation, or the like, carried out by said power converter $C_i$.

Of course, the above considerations are valid *mutatis mutandis* for other types of above-mentioned DC electric power sources depending on their operational characteristic curves.

In order to control the above-mentioned power converters, the control means 140 may be configured to provide suitable control signals, control variables, reference currents, reference voltages, control flags and the like.

Preferably, the inverter 100 comprises sensing means 150 adapted to provide the control means 140 with detection signals M indicative of the input voltages $V_1, V_2, ..., V_{i-1}, V_i, ..., V_{N-1}, V_N$ of the input channels $CH_1, ..., CH_N$ (more precisely at the input terminals of said input channels).

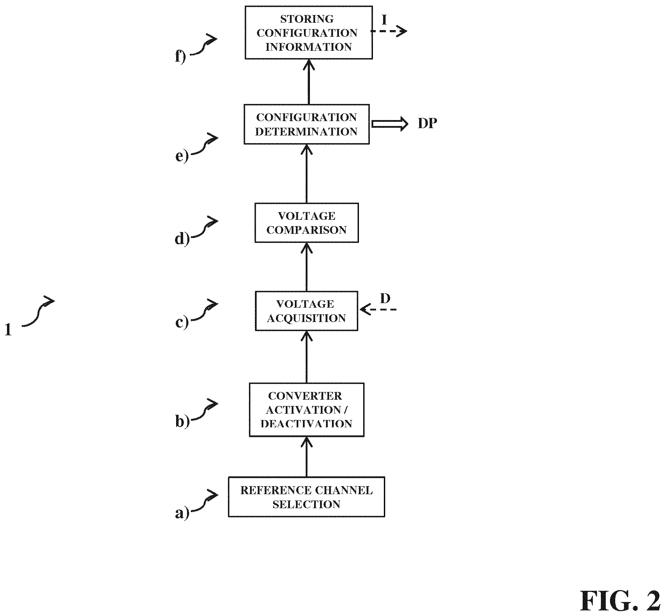

In general, the DC electric system 200 (e.g. the DC sources $S_1, ..., S_N$ thereof), the AC electric system 300 and most of the components of the input section 110 (e.g. the input channel channels $CH_1, ..., CH_N$ and the corresponding converters $C_1, ..., C_N$ thereof), of the output section 120 and, possibly, of the coupling section 130 as well as the sensing means 150 may be of known type and will not be here described in further details for the sake of brevity. With particular reference to figures 2, 3A, 3B, and 9, the method 1, according to the invention, is now described in details.

In general terms, the method 1 is aimed at detecting the input channel configuration of the multi-channel inverter 100.

For the sake of clarity, it is specified that the locution "detecting an input channel configuration of the multi-channel inverter" means the detection of the physical connection arrangement of the input channels of said inverter with a DC electric source, in practice detecting whether the input channels of said inverter are electrically connected in parallel with a same DC source or are singularly connected with a corresponding DC source.

In the following, for the sake of brevity, an input channel singularly connected with a corresponding DC electric power source is defined as "independent input channel" whereas input channels electrically connected in parallel with a same DC electric power source are defined as "parallel input channels".

The method 1 comprises a step a) of selecting a reference input channel (e.g. the input $CH_1$) among the

input channels $CH_1$, ..., $CH_N$ of the inverter 100.

In a practical implementation of the invention, the reference input channel $CH_1$ may be selected in a group of available input channels according to a predefined sorting order or according to a random sorting order.

As it will better emerge from the following, such a group of available input channels initially include all the input channels of the inverter 100. However, said group of available input channels comprises only selected input channels of the inverter 100 (in particular those still having an undetermined configuration status), when the method 1 is recursively repeated.

Upon carrying out the above-illustrated step a), the method 1 comprises a step b) of controlling the power converters $C_1$, ..., $C_N$ to allow an input current $I_1$ higher than a current threshold $I_{TH}$ to flow along the reference input channel $CH_1$ and to allow input currents $I_2$, ..., $I_N$ lower than said current threshold to flow along one or more remaining input channels $CH_2$, ..., $CH_N$ different from the reference input channel $CH_1$.

In a preferred embodiment of the invention, the above-mentioned step b) comprises activating the power converter $C_1$ corresponding to the selected reference input channel $CH_1$ and deactivating the power converters $C_2$, ..., $C_N$ corresponding to the remaining input channels $CH_2$, ..., $CH_N$.

Such preferred embodiment of the invention corresponds to the case in which the current threshold $I_{TH}$ is set as $I_{TH} = 0$ A.

However, other embodiments of the invention may provide for activating all the power converters $C_1$, ..., $C_N$ and controlling these latter in such a way that, at a given check instant, the input current $I_1$ flowing along the reference input channel $CH_1$ is higher than the current threshold $I_{TH}$ whereas the input currents $I_2$, ..., $I_N$ flowing along the remaining input channels $CH_2$, ..., $CH_N$ is lower than said current threshold.

To this aim, for example, the power converters $C_1$, ..., $C_N$ may be controlled in such a way that, at a given check instant, an input current $I_1$ having a higher growth rate is allowed to flow along the reference input channel $CH_1$ and input currents $I_2$, ..., $I_N$ having lower growth rates are allowed to flow along the remaining input channels $CH_2$, ..., $CH_N$.

According to other embodiments (not shown), both the above-mentioned solutions or additional equivalent solutions may be implemented.

Upon carrying out the above-illustrated step b), the method 1 comprises a step c) of acquiring detection data D indicative of the input voltages $V_1$, ..., $V_N$ of the input channels $CH_1$, ..., $CH_N$ of the inverter 100 (more precisely at the input terminals of said input channels).

In a practical implementation of the invention, the detection data D may be acquired by suitably processing the detection signals M received from the above-mentioned sensing means 150.

Upon carrying out the above-illustrated step c), the method 1 comprises a step d) of performing a comparison between the input voltage $V_1$ of the reference channel $CH_1$ and each of the input voltages $V_2$, ..., $V_N$ of the remaining input channels $CH_2$, ..., $CH_N$ based on the detection data D so acquired.

Preferably, the above-mentioned step d) comprises checking whether the input voltages $V_2$, ..., $V_N$ of the remaining input channels $CH_2$, ..., $CH_N$ behave (more particularly decrease) as the input voltage $V_1$ of the reference input channel $CH_1$.

In a practical implementation of the invention, at a given check instant, the voltage differences between each input voltage $V_2$, ..., $V_N$ of the remaining input channels $CH_2$, ..., $CH_N$ and the input voltage $V_1$ of the reference channel $CH_1$ may be calculated and compared with predefined threshold values to determine whether the compared input voltages behave in a similar manner or in a different manner.

As an example, the voltages $V_1$, $V_2$ of the input channels $CH_1$, $CH_2$ can be determined as behaving in a same or different manner depending on whether the following relation is true or false at a given check instant:

$$\Delta V_{21} = |V_2 - V_1| < V_{TH}$$

where $V_{TH}$ is a predefined threshold value.

Upon carrying out the above-illustrated step d), the method 1 comprises a step e) of carrying out a determination procedure DP to determine the configuration status of the input channels $CH_1$, $CH_2$, ..., $CH_N$ based on behavior of the input voltages $V_2$, ..., $V_N$ of the remaining input channels $CH_2$, ..., $CH_N$ with respect to the input voltage $V_1$ of the selected reference channel $CH_1$.

In general terms, the determination procedure DP allows determining the input channel configuration of the inverter 100 properly observing the behavior of the input voltages at said input channels (more precisely at the input terminals of said input channels).

At a given check instant, upon the execution of the step b) of the method 1), a certain input current $I_1$ flows along the reference input channel $CH_1$ whereas null or lower input currents $I_2$, ..., $I_N$ flow along the remaining input channels $CH_2$, ..., $CH_N$.

Referring to figure 10, this means that, upon the execution of the step b) of the method 1, the DC source $S_1$ electrically connected with the reference input channel $CH_1$ operates at a working point $WP_2$, at which the input voltage $V_1$ of the reference input channel $CH_1$ decreases to the value $V_1 = V_A$.

As a consequence, the input voltage of possible remaining input channels electrically connected in parallel with the reference input channel $CH_1$ will follow the input voltage $V_1$ of the reference input channel $CH_1$ thereby decreasing from its no-load voltage value $V_{OC}$ to the value $V_1 = V_A$.

On the other hand, the input voltage of possible remaining input channels not electrically connected in parallel with the reference input channel $CH_1$ will stably

remain at its no-load voltage value $V_{OC}$ or will decrease to a value $V_Q$ higher than $V_1=V_A$ (e.g. in a neighborhood of the voltage value Voc) as null currents or currents lower than the current $I_1=I_A$ are allowed to flow along said input channels.

The physical connection arrangement of each input channel $CH_1, ..., CH_N$ can thus be determined by properly observing the behavior of the input voltages $V_2, ..., V_N$ of the remaining input channels $CH_2, ..., CH_N$ in relation to the input voltage $V_1$ of the reference channel $CH_1$.

More particularly, the configuration status of each input channel $CH_1, ..., CH_N$ can be determined by properly checking whether the input voltages $V_2, ..., V_N$ of the remaining input channels $CH_2, ..., CH_N$ decrease as the input voltage $V_1$ of the reference input channel $CH_1$. As illustrated above, the voltage differences between each of the input voltages $V_2, ..., V_N$ of the remaining input channels $CH_2, ..., CH_N$ and the input voltage $V_1$ of the reference channel $CH_1$ may be calculated and compared with predefined threshold values to carry out such a checking activity.

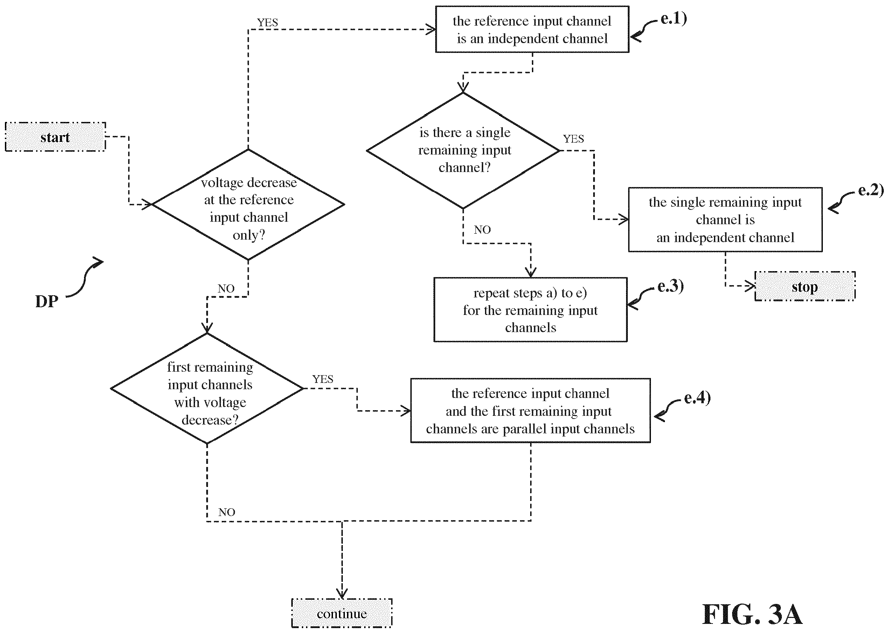

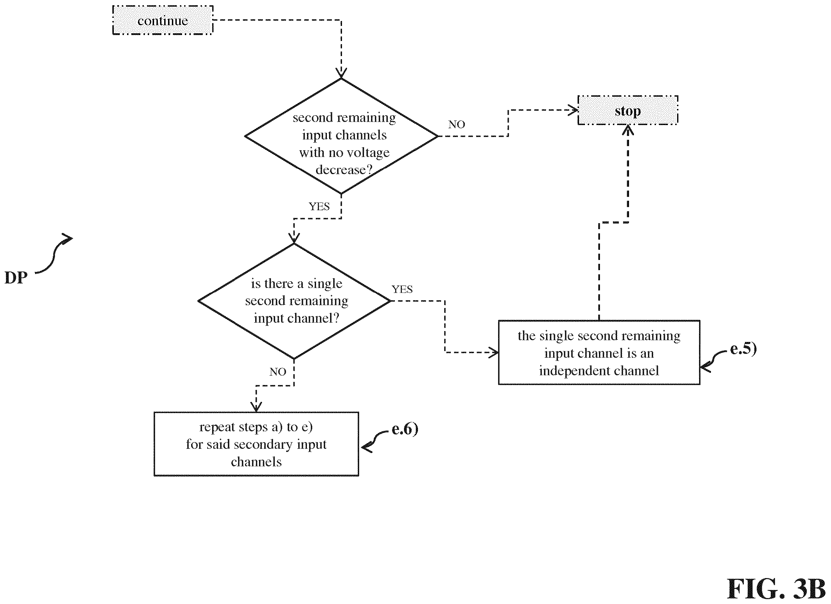

Preferably, the above-mentioned step e) of the method 1 comprises a structured determination procedure DP to determine the input channel configuration of the inverter 100 on the basis of the of the detection data D (figures 3A-3B).

Initially, the method 1 provides for considering the preliminary event, according to which only the input voltage $V_1$ of the reference input channel $CH_1$ decreases upon the execution of the step b) of the method 1.

If such a preliminary event is verified, the reference input channel $CH_1$ cannot be electrically connected in parallel with any remaining input channel $CH_2, ..., CH_N$ of the inverter 100 as none of the input voltages $V_2, ..., V_N$ of said remaining input channels behaves (i.e. decreases) as the input voltage $V_1$ of the reference input channel $CH_1$, upon the execution of the step b) of the method 1.

This means that the reference input channel $CH_1$ is an independent channel.

In view of the above, the determination procedure DP preferably comprises a step e.1) of determining that the reference input channel $CH_1$ is an independent channel, if the input voltages $V_2, ..., V_N$ of the remaining input channels $CH_2, ..., CH_N$ do not decrease as the input voltage $V_1$ of the reference input channel $CH_1$.

In other words, according to the step e.1), the reference input channel $CH_1$ is determined as an independent channel, if none of the input voltages $V_2, ..., V_N$ of the remaining input channels $CH_2, ..., CH_N$ decreases as the input voltage $V_1$ of the reference input channel $CH_1$ upon the execution of the step b) of the method 1.

At this level of the determination process, the subsequent steps of the determination procedure DP depend on whether the remaining input channels $CH_2, ..., CH_N$ include a single input channel or multiple input channels.

If a single remaining input channel (e.g. the step $CH_2$) is present, this latter is necessarily an independent channel.

In this case, in fact, the inverter 100 would necessarily include two input channels $CH_1, CH_2$ only, one of which (the reference input channel $CH_1$) has already been determined as an independent channel.

For this reason, upon the execution of the above mentioned step e.1), the determination procedure DP preferably comprises the following step e.2): if there is a single remaining input channel, determining that said single remaining input channel is an independent input channel.

Upon the execution of the step e.2), the determination procedure DP is terminated as it has been possible to determine the configuration of all the input channels (e.g. $CH_1$ and $CH_2$) of the inverter 100.

If the remaining input channels $CH_2, ..., CH_N$ include multiple input channels, no determination can be taken on said remaining input channels, even if the reference input channel $CH_1$ has already been determined an independent input channel.

In fact, since the power converters $C_2, ..., C_N$ operatively associated to the remaining input channels $CH_2, ..., CH_N$ are deactivated or low currents flow said remaining input channels, the input voltages $V_2, ..., V_N$ of the remaining input channels $CH_2, ..., CH_N$ stably remain at their no-load voltage values or take values higher than the input voltage $V_1$ and no information on their configuration can be derived from such a behavior. For example, they may be all configured as independent channels or some of them may be electrically connected in parallel with a same DC source.

For this reason, upon the execution of the above mentioned step e.1), alternatively with respect to the above-mentioned step e.2), the determination procedure DP preferably comprises the step e.3) of repeating the above mentioned steps a), b), c), d), e) for the remaining input channels $CH_2, ..., CH_N$, if there is a plurality of remaining input channels $CH_2, ..., CH_N$.

In practice, in this case, the method 1 is recursively executed for a new group of available input channels, which includes all the multiple remaining input channels $CH_2, ..., CH_N$ and which does not include the previously selected reference input channel $CH_1$.

Obviously, during such a recursive execution of the method 1, a new reference input channel and new remaining input channels have to be selected among the remaining input channels $CH_2, ..., CH_N$ in accordance with the step a) of the method 1.

If the input voltages of one or more first remaining input channels $CH_2, ..., CH_{i-1}$ of the inverter 100 decrease as the input voltage $V_1$ of the reference input channel $CH_1$, it means that the reference input channel $CH_1$ and said first remaining input channels are electrically connected in parallel with a same DC source (formed by the coincident DC sources $S_2, ..., S_{i-1}$) as their input voltages $V_1, V_2, ..., V_{i-1}$ behave (i.e. decrease) in a similar way upon the execution of the step b) of the method 1.

For this reason, the determination procedure DP preferably comprises the following step e.4): if the input voltages $V_2, ..., V_{i-1}$ of one or more first remaining input channels $CH_2, ..., CH_{i-1}$ decrease as the input voltage $V_1$ of the reference input channel $CH_1$, determining that the reference input channel $CH_1$ and the first remaining input channels $CH_2, ..., CH_{i-1}$ are parallel input channels.

At this level of the determination process, as logic alternatives to the above-described condition, the following possible events may occur:

- there are no first remaining input channels with input voltages decreasing as the input voltage of the reference input channel; or
- the above-mentioned first remaining channels do not include all the remaining input channels.

In both these cases, it is necessary to check whether there are second remaining input channels (e.g. the input channels $CH_i, ..., CH_N$) different from the first remaining input channels $CH_2, ..., CH_{i-1}$ having input voltages $V_i, ..., V_N$ that do not decrease as the input voltage $V_1$ of the reference input channel $CH_1$.

If there are no second remaining input channels $CH_i, ..., CH_N$, the input voltage of which does not decrease as the input voltage $V_1$ of the reference input channel $CH_1$, the determination procedure DP is terminated.

Such an event, in fact, would necessarily imply that the above-mentioned first remaining channels $CH_2, ..., CH_{i-1}$ (the configuration of which is already determined) include all the input channels of the inverter 100 different from the reference input channel $CH_1$ (in practice all the above-mentioned remaining input channels of the inverter 100).

If there are second remaining input channels $CH_i, ..., CH_N$, the input voltage of which does not decrease as the input voltage $V_1$ of the reference input channel $CH_1$, the subsequent determination steps of the determination procedure DP depend on whether said second remaining input channels include a single input channel or multiple input channels.

If the second remaining input channels of the inverter 100 include a single input channel, this latter is necessarily an independent channel.

In this case, in fact, such a second remaining input channel would be the only channel with an input voltage that does not decrease as the input voltages of the other input channels (i.e. the reference input channel and the first remaining input channel) of the inverter 100.

For this reason, upon the execution of the above mentioned step e.4), the determination procedure DP preferably comprises the following step e.5): if there is a single second remaining input channel, determining that said single second remaining input channel is an independent input channel.

Upon the execution of the step e.5), the determination procedure DP is virtually terminated as it has been possible to determine the configuration of all the input channels of the inverter 100.

If the second remaining input channels of the inverter 100 include multiple input channels, no determination can be taken on the configuration status of said input channels.

In fact, upon the execution of the step b) of the method 1, these second remaining input channels stably remain at their no-load voltage values or take values higher than the input voltage $V_1$ and no information on their configuration can be derived from such a behavior. For this reason, upon the execution of the above mentioned step e.5), the determination procedure DP preferably comprises the step e.6): if there is a plurality of second remaining input channels, repeating the above mentioned steps a), b), c), d), e) for said second remaining input channels.

In practice, in this case, the method is recursively executed for a new group of available input channels, which include the second remaining input channels $CH_i, ..., CH_N$ only and which does not include the reference input channel $CH_1$ and the first remaining input channels $CH_2, ..., CH_{i-1}$.

Obviously, during such a new recursive execution of the method 1, a new reference input channel and new remaining input channels have to be selected among said second remaining input channels $CH_i, ..., CH_N$ in accordance with the step a) of the method 1.

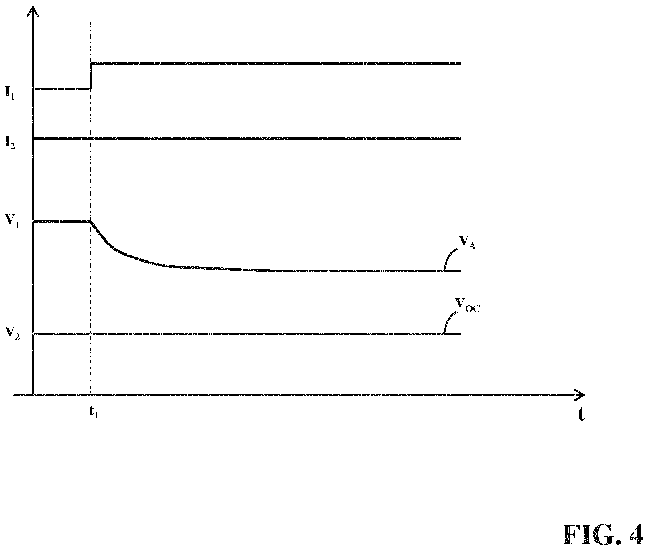

Referring now to figures 4-9, some examples of implementation of the method 1 to better explain the determination process, which is implemented by the determination procedure DP, are described.

For the sake of simplicity, the following examples #1 to #5 (figures 4-8) refer to the preferred embodiment in which, at the step b) of the method 1, the power converter corresponding to the reference input channel is activated whereas the one or more power converters operatively associated to one or more remaining input channels are maintained deactivated.

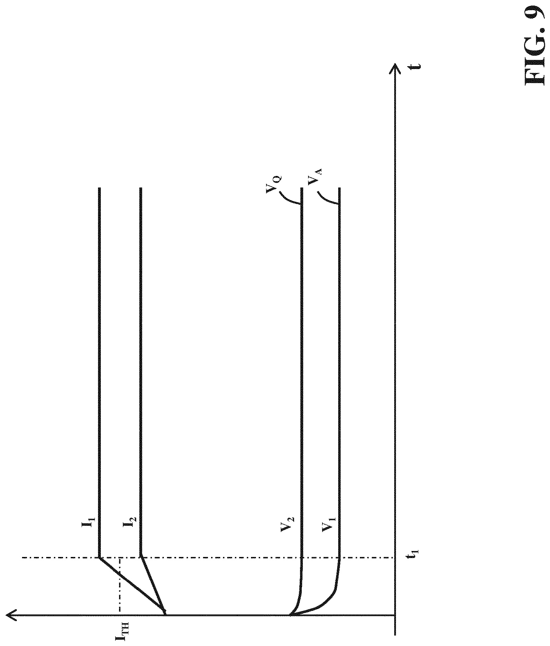

Example #6 (figure 9) instead refers to the more general case in which, at the step b) of the method 1, the power converters $C_1, ..., C_N$ are controlled in such a way the input current flowing along the reference input channel is set higher than a current threshold $I_{TH}$ and the input currents flowing along the remaining input channels are set lower than said current threshold.

EXAMPLE #1

The inverter 100 is supposed to have two input channels $CH_1, CH_2$ electrically connected with corresponding DC sources $S_1, S_2$ and corresponding power converters $C_1, C_2$ that are supposed to be initially deactivated.

According to the step a) of the method 1, the

input channel $CH_1$ is selected as a reference input channel. As a consequence, the input channel $CH_2$ represents the remaining input channel of the inverter 100 as defined above.

According to the step b) of the method 1, at a given check instant $t_1$, the power converter $C_1$ corresponding to the reference input channel $CH_1$ is activated whereas the power converter $C_2$ operatively associated to the remaining input channel $CH_2$ is maintained deactivated. According to the steps c)-d) of the method 1, detection data D related to the input voltages $V_1$, $V_2$ of the input channels $CH_1$, $CH_2$ are acquired and compared.

As it is possible to observe from figure 4, following the activation of the power converter $C_1$ at the check instant $t_1$, the input voltage $V_1$ of the reference input channel $CH_1$ starts naturally decreasing towards a given operating value $V_A$. This latter value depends on the current regulation performed by the power converter $C_1$ (figure 10). Instead, the input voltage $V_2$ of the remaining input channel $CH_2$ stably remains at its no-load value Voc.

According to the steps e.1)-e.2) of the determination procedure DP, both the input channels $CH_1$, $CH_2$ are determined as independent input channels.

The determination of the configuration status of the input channels of the inverter 100 is completed.

EXAMPLE #2

In this example, the inverter 100 is arranged as in the example #1, i.e. it comprises two input channels $CH_1$, $CH_2$.

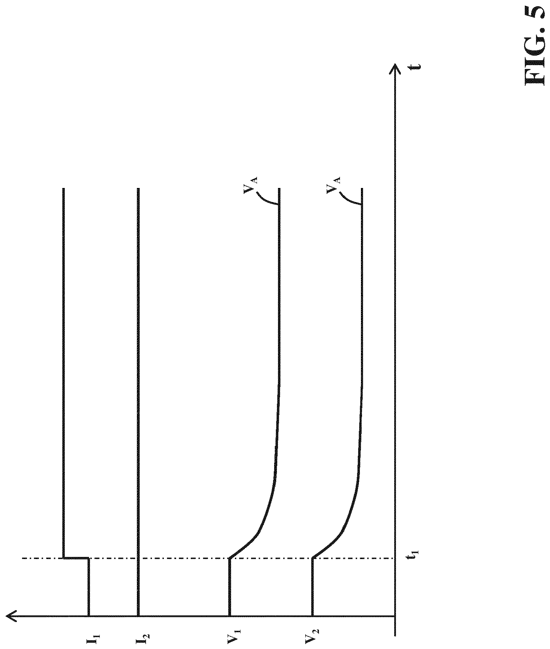

As it is possible to observe from figure 5, differently from the previous example, following the activation of the power converter $C_1$ at the check instant $t_1$, the input voltage $V_2$ of the remaining input channel $CH_2$ behaves as the input voltage $V_1$ of the reference input channel $CH_1$, i.e. it starts decreasing towards a same given operating value $V_A$.

According to the step e.4) of the determination procedure DP, both the input channels $CH_1$, $CH_2$ are determined as parallel input channels.

The determination of the configuration status of the input channels of the inverter 100 is completed.

EXAMPLE #3

The inverter 100 is supposed to have three input channels $CH_1$, $CH_2$, $CH_3$ electrically connected with corresponding DC sources $S_1$, $S_2$, $S_3$ and corresponding power converters $C_1$, $C_2$, $C_3$ that are supposed to be initially deactivated.

According to the step a) of the method 1, the input channel $CH_1$ is selected as a reference input channel. As a consequence, the input channels $CH_2$, $CH_3$ represent the remaining input channels of the inverter 100 as defined above.

According to the step b) of the method 1, at a given check instant $t_1$, the power converter $C_1$ corre-

sponding to the reference input channel $CH_1$ is activated whereas the power converters $C_2$, $C_3$ operatively associated to the remaining input channels $CH_2$, $CH_3$, are maintained activated.

According to the steps c)-d) of the method 1, detection data D related to the input voltages $V_1$, $V_2$, $V_3$ of the input channels $CH_1$, $CH_2$, $CH_3$ are acquired and compared.

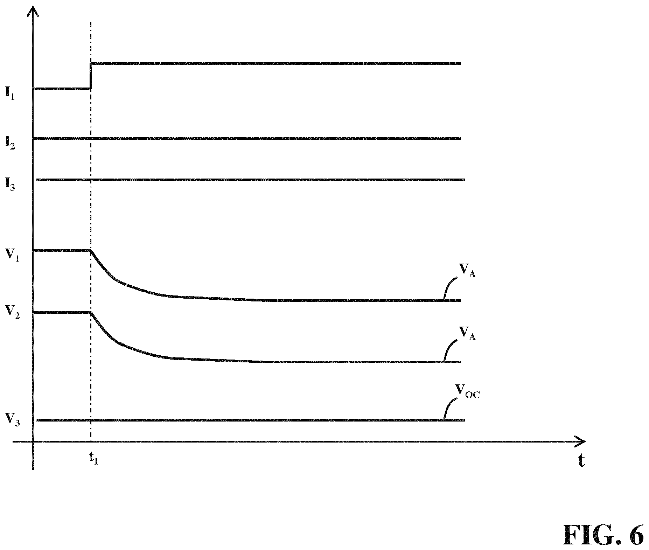

As it is possible to observe from figure 6, following the activation of the power converter $C_1$ at the check instant $t_1$, the input voltage $V_2$ of the remaining input channel $CH_2$ behaves as the input voltage $V_1$ of the reference input channel $CH_1$, i.e. it starts decreasing towards a same given operating value $V_A$. Instead, the input voltage $V_3$ of the remaining input channel $CH_3$ stably remains at its no-load value Voc.

According to the steps e.4) and e.5) of the determination procedure DP, the input channels $CH_1$, $CH_2$ are determined as parallel input channels whereas the input channel $CH_3$ is determined as an independent input channel.

The determination of the configuration status of the input channels of the inverter 100 is completed.

EXAMPLE #4

In this example, the inverter 100 is arranged as in the example #3, i.e. it comprises three input channels $CH_1$, $CH_2$, $CH_3$.

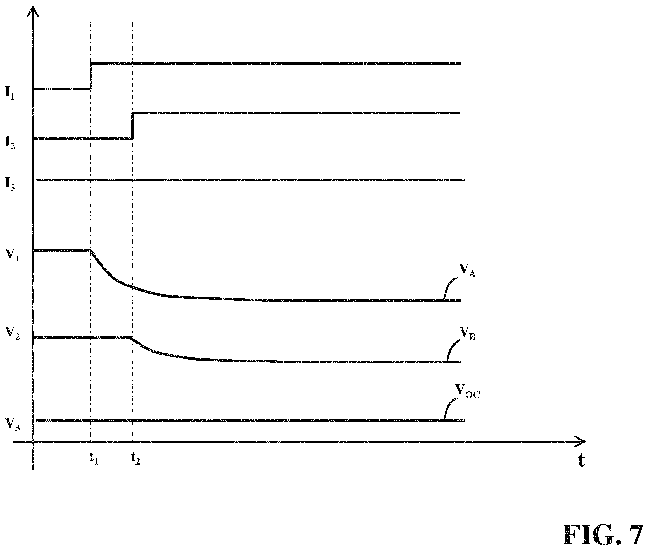

As it is possible to observe from figure 7, differently from the previous example, following the activation of the power converter $C_1$ at the check instant $t_1$, only the input voltage $V_1$ of the reference input channel $CH_1$ starts decreasing towards a given operating value $V_A$. Instead, the input voltages $V_2$, $V_3$ of the remaining input channels $CH_2$, $CH_3$ stably remain at their no-load values $V_{OC}$.

According to the step e.1) of the method 1, the input channel $CH_1$ is determined as an independent input channel.

However, the determination of the configuration status of the input channels of the inverter 100 is not completed at this level of the determination procedure.

In fact, no determination can be taken for the channels $CH_2$, $CH_3$ as their input voltages $V_2$, $V_3$ stably remain at their no-load values $V_{OC}$ following the activation of the power converter $C_1$ at the check instant $t_1$.

According to the step e.3) of the determination procedure DP, the steps a)-e) of the method 1 are recursively repeated for the input channels $CH_2$, $CH_3$ only.

According to the step a) of the method 1, the input channel $CH_2$ is selected as new reference input channel. Accordingly, the input channel $CH_3$ represents the new remaining channel of the inverter 100 as defined above.

According to the step b) of the method 1, at a given check instant $t_2$, the power converter $C_2$ corresponding to the new reference input channel $CH_2$ is ac-

tivated whereas the power converter $C_3$ operatively associated to the new remaining input channel $CH_3$ is maintained deactivated.

According to the steps c)-d) of the method 1, detection data D related to the input voltages $V_2$, $V_3$ of the input channels $CH_2$, $CH_3$ are acquired and compared.

As it is possible to observe from figure 7, following the activation of the power converter $C_2$ at the check instant $t_2$, the input voltage $V_2$ of the reference input channel $CH_2$ starts decreasing towards a given operating value $V_B$. This latter value depends on the current regulation performed the power converter $C_2$. Instead, the input voltage $V_3$ of the remaining input channel $CH_3$ stably remains at its no-load value $V_{OC}$.

According to the steps e.1)-e.2) of the determination procedure DP, both the input channels $CH_2$, $CH_3$ are determined as independent input channels.

The determination of the configuration status of the input channels of the inverter 100 is now completed.

<u>EXAMPLE #5</u>

The inverter 100 is supposed to have six input channels $CH_1$, $CH_2$, $CH_3$, $CH_4$, $CH_5$, $CH_6$ electrically connected with corresponding DC sources $S_1$, $S_2$, $S_3$, $S_4$, $S_5$, $S_6$ and corresponding power converters $C_1$, $C_2$, $C_3$, $C_4$, $C_5$, $C_6$ that are supposed to be initially deactivated. According to the step a) of the method 1, the input channel $CH_1$ is selected as a reference input channel. The input channels $CH_2$, $CH_3$, $CH_4$, $CH_5$, $CH_6$ represent the remaining input channels of the inverter 100 as defined above.

According to the step b) of the method 1, at a given check instant $t_1$, the power converter $C_1$ corresponding to the reference input channel $CH_1$ is activated whereas the power converters $C_2$, $C_3$, $C_4$, $C_5$, $C_6$, operatively associated to the remaining input channels $CH_2$, $CH_3$, $CH_4$, $CH_5$, $CH_6$, are maintained deactivated.

According to the steps c)-d) of the method 1, detection data D related to the input voltages $V_1$, $V_2$, $V_3$, $V_4$, $V_5$, $V_6$ of the input channels are acquired and are compared.

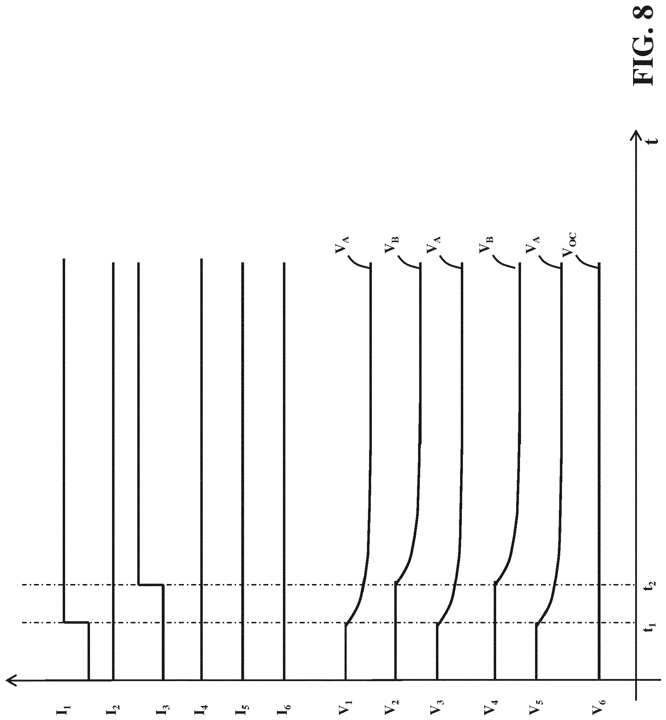

As it is possible to observe from figure 8, following the activation of the power converter $C_1$ at the check instant $t_1$, the input voltages $V_3$, $V_5$ of the remaining input channels $CH_3$, $CH_5$ behave as the input voltage $V_1$ of the reference input channel $CH_1$, i.e. they start decreasing towards a same given operating value $V_A$. Instead, the input voltages $V_2$, $V_4$, $V_6$ of the remaining input channels $CH_2$, $CH_4$, $CH_6$ stably remain at their no-load values Voc. According to the steps e.4) and e.5) of the determination procedure DP, the input channels $CH_1$, $CH_3$, $CH_5$ are determined as parallel channels.

However, the determination of the configuration status of the input channels of the inverter 100 is not completed at this level of the determination procedure.

In fact, no determination can be taken for the channels $CH_2$, $CH_4$, $CH_6$ as their input voltages $V_2$, $V_4$, $V_6$ stably remain at their no-load values $V_{OC}$ following the activation of the power converter $C_1$ at the check instant $t_1$.

According to the step e.6) of the method 1, the steps a)-e) of the method are recursively repeated for the input channels $CH_2$, $CH_4$, $CH_6$ only.

According to the step a) of the method 1, the input channel $CH_2$ is selected as new reference input channel. Accordingly, the input channels $CH_4$, $CH_6$ represent the new remaining channels of the photovoltaic inverter as defined above.

According to the step b) of the method 1, at a given check instant $t_2$, the power converter $C_2$ corresponding to the new reference input channel $CH_2$ is activated the power converters $C_3$, $C_6$, operatively associated to the new remaining input channels $CH_4$, $CH_6$, are maintained deactivated.

According to the steps c)-d) of the method 1, detection data D related to the input voltages $V_2$, $V_4$, $V_6$ of the input channels $CH_2$, $CH_4$, $CH_6$ are acquired and compared.

As it is possible to observe from figure 8, following the activation of the power converter $C_2$ at the check instant $t_2$, the input voltage $V_4$ of the new remaining input channel $CH_4$ behaves as the input voltage $V_2$ of the new reference input channel $CH_2$, i.e. it starts decreasing towards a given operating value $V_B$. Instead, the input voltage $V_6$ of the new remaining input channel $CH_6$ stably remains at its no-load value Voc.

According to the steps e.4) and e.5) of the determination procedure DP, the input channels $CH_2$, $CH_4$ are determined as parallel input channels whereas the input channel $CH_6$ is determined as an independent input channel.

The determination of the configuration status of the input channels of the inverter 100 is now completed.

<u>EXAMPLE #6</u>

In this example, the inverter 100 is arranged as in the example #1, i.e. it comprises two input channels $CH_1$, $CH_2$.

According to the step a) of the method 1, the input channel $CH_1$ is selected as a reference input channel. As a consequence, the input channel $CH_2$ represents the remaining input channel of the inverter 100 as defined above.

According to the step b) of the method 1, at a given check instant $t_1$, the power converters C1, C2 are controlled in such a way that the power converter $C_1$ corresponding to the reference input channel $CH_1$ is fed with a current $I_1$ higher than a given threshold $I_{TH}$ and the power converter $C_2$ operatively associated to the remaining input channel $CH_2$ is fed with a current $I_2$ lower than a given threshold $I_{TH}$.

To this aim, as shown in figure 10, the power converters C1, C2 are controlled in such a way that the power converter $C_1$ corresponding to the reference input

channel $CH_1$ is fed with a current $I_1$ having a higher growth rate and the power converter $C_2$ operatively associated to the remaining input channel $CH_2$ is fed with a current $I_2$ having lower than a lower growth rate.

According to the steps c)-d) of the method 1, detection data D related to the input voltages $V_1$, $V_2$ of the input channels $CH_1$, $CH_2$ are acquired and compared.

As it is possible to observe in figure 9, following the activation of the power converter $C_1$ at the check instant $t_1$, the input voltage $V_1$ of the reference input channel $CH_1$ starts naturally decreasing towards a given operating value $V_A$. This latter value depends on the current regulation performed by the power converter $C_1$ (figure 10). Instead, the input voltage $V_2$ of the remaining input channel $CH_2$ decrease to a voltage $V_Q$ higher than $V_A$.

According to the steps e.1)-e.2) of the determination procedure DP, both the input channels $CH_1$, $CH_2$ are determined as independent input channels.

The determination of the configuration status of the input channels of the inverter 100 is completed.

This example clearly shows that the determination of the configuration status of the input channels can be suitably carried out also in the general case in which the power converters $C_1$, ..., $C_N$ are controlled in such a way the input current flowing along the reference input channel is set higher than the current threshold $I_{TH}$ and the input currents flowing along the remaining input channels are set lower than said current threshold.

In this respect, further examples similar to examples #2 to #5 may be easily provided by simply considering different current profiles for the input currents $I_1$, ..., $I_N$ flowing along the input channels $CH_1$, ..., $CH_N$.

The above examples clearly show how the input channel configuration of the inverter 100 can be determined based on the detection data D by observing behavior of the input voltages $V_1$, ..., $V_N$ of the input channels $CH_1$, ..., $CH_N$ following a selective current feeding of the input channels $CH_1$, ..., $CH_N$, e.g. obtained through a selective activation and deactivation of the power converters $C_1$, ..., $C_N$ corresponding to said input channels or by controlling said power converters in such a way that said input channels are fed with currents having selected profiles.

According to a preferred embodiment of the invention, the method 1 comprises the step f) of storing information I indicative of the configuration status determined for the input channels $CH_1$, ..., $CH_N$ of the inverter 100.

Preferably, the step f) of the method 1 is carried out concurrently with the execution of the step e), for example each time the configuration status of an input channel is taken into consideration during the above-mentioned determination procedure.

The configuration information I attributed to the input channels $CH_1$, ..., $CH_N$ during the execution of the determination procedure DP is conveniently formed by suitable sets of bits (variable values) stored in a memory.

As an example, each input channel may be labeled as "independent", "parallel" or "undetermined" depending on the determination taken on its configuration status or depending on the level reached in the decision process implemented by the determination procedure DP.

Of course, when the execution of the step e) is completed, all the input channels of the inverter 100 are expected to be labeled as "independent" or "parallel".

The stored configuration information I is used by the control means 140 for controlling the operation of the inverter 100, e.g. for carrying out a MMPT regulation of the electric power generated and transmitted to the electric power distribution grid.

Conveniently, in its practical implementation, the method 1 is particularly adapted for being executed by data processing resources residing in the inverter 100.

Preferably, the method 1 is executed by the above-mentioned data-processing resources 160 of the control means 140 of the inverter 100.

The method, according to the present invention, provides several advantages with respect to the state of the art.

The method, according to the invention, allows automatically determining with high levels of accuracy the configuration status of the input channels of a photovoltaic inverter.

The photovoltaic inverter can thus behave as a "plug & play" apparatus capable of storing the required configuration information related to the configuration status of the input channels without the intervention of an external operator, simply carrying out the method of the invention at each power-up.

This feature allows achieving a remarkable reduction of the commissioning time and costs to put the photovoltaic inverter in condition for properly operating.

Additionally, an improvement of the overall control functionalities of the photovoltaic inverter can be achieved as human errors in setting the above-mentioned configuration information are avoided.

The method, according to the invention, is characterized by a high level of flexibility in its practical implementation. Thus, it may be successfully adopted in multi-channels photovoltaic inverters of different types, e.g. having different numbers of input channels.

The method, according to the invention, is of relatively easy implementation at industrial level. As an example, it may be easily carried out by processing devices on board the photovoltaic inverter, such as microcontrollers or DSPs.

## Claims

1. Method (1) for detecting an input channel configuration of a multi-channel inverter (100) having a plurality of input channels ($CH_1$, $CH_2$, $CH_{i-1}$, $CH_i$, $CH_{N-1}$, $CH_N$), each input channel being electrically connected with a corresponding power converter ($C_1$, $C_2$,

$C_{i-1}$, $C_i$, $C_{N-1}$, $C_N$) and, upon an operative installation of said multi-channel inverter, being electrically connectable to a DC electric power source ($S_1$, $S_2$, $S_{i-1}$, $S_i$, $S_{N-1}$, $S_N$), and to an AC electric system (300), the input channel configuration being indicative of the physical connection status of the input channels, such as independent or parallel, **characterized in that** it comprises the following steps:

   a) selecting a reference input channel among said input channels;
   b) controlling said power converters so that an input current higher than a current threshold is set along said reference input channel and so that input currents lower than said current threshold are set along one or more remaining input channels different from said reference input channel;
   c) acquiring detection data (D) indicative of input voltages ($V_1$, $V_2$, Vi-i, $V_i$, $V_{N-1}$, $V_N$) of said input channels following a selective current feeding of said input channels obtained by controlling said power converters in such a way that said input channels are fed with currents having selected profiles or different growth rates;
   d) performing a comparison between the input voltages of said input channels based on said detection data, said comparison including calculating the voltage differences between the input voltages of said remaining input channels and the input voltage of said reference channel and comparing said voltage differences with predefined threshold values;
   e) executing a determination procedure (DP) to determine a configuration status of said input channels based on a behavior of the input voltages of said remaining input channels with respect to the input voltage of said reference channel, the configuration status of each input channel being determined by checking whether the input voltages of said remaining input channels decrease as the input voltage of said reference input channel.

2. Method, according to claim 1, **characterized in that** said step b) of controlling said power converters comprises activating the power converter corresponding to said reference input channel and deactivating or maintaining deactivated the power converters corresponding to said remaining input channels.

3. Method, according to one or more of the previous claims, **characterized in that** said step d) of performing a comparison between the input voltages of said input channels comprises checking whether the input voltages of said remaining input channels behave as the input voltage of said reference input channel.

4. Method, according to claim 3, **characterized in that** said determination procedure (DP) comprises the following step:
   e.1) if the input voltages of said remaining input channels do not decrease as the input voltage at said reference input channel, determining that said reference input channel is an independent input channel.

5. Method, according to claim 4, **characterized in that** said determination procedure further comprises the following steps:

   e.2) if there is a single remaining input channel, determining that said remaining input channel is an independent input channel; or
   e.3) if there is a plurality of remaining input channels, repeating said steps a), b), c), d), e) for said remaining input channels.

6. Method, according to claim 3, **characterized in that** said determination procedure (DP) comprises the following step:
   e.4) if the input voltages of one or more first remaining input channels decrease as the input voltage at said reference input channel, determining that said reference input channel and said one or more first remaining input channels are parallel input channels.

7. Method, according to claim 6, **characterized in that** if the input voltages of one or more second remaining input channels, different from said first remaining input channels, do not decrease as the input voltage of said reference input channel said determination procedure (DP) comprises the following steps:

   e.5) if said second remaining channels include a single second remaining input channel, determining that said remaining input channel is an independent input channel; or
   e.6) if said second remaining channels include a plurality of second remaining input channels, repeating said steps a), b), c), d), e) for said second remaining input channels.

8. Method, according to one or more of the previous claims, **characterized in that** it comprises the step f) of storing configuration information (I) indicative of the configuration status determined for said input channels.

9. A multi-channel inverter (100) comprising an input section (110) that, in operation, is configured to be electrically connected with a DC electric system (200) adapted to provide DC electric power in output, the input section (110) comprising a plurality of input channels ($CH_1$, $CH_2$, $CH_{i-1}$, $CH_i$, $CH_{N-1}$, $CH_N$), each of which is electrically connected with a corresponding power converter ($C_1$, $C_2$, $C_{i-1}$, $C_i$, $C_{N-1}$, $C_N$) and configured to be electrically connected with a DC electric power source ($S_1$, $S_2$, $S_{i-1}$, $S_i$, $S_{N-1}$, $S_N$), further comprising an output section (120) that, in operation, is configured to be electrically connected with an AC electric system (300) when the inverter (100) is installed on a field, such that commissioning time and costs can be lowered, **characterized in that** the multi-channel inverter (100) comprises data processing resources (160) configured to execute a method (1), according to one or more of the previous claims.

10. A multi-channel inverter, according to claim 9, **characterized in that** it comprises control means (140) to control the operation of said photovoltaic inverter, said control means comprising data processing resources (160) configured to execute a method (1), according to one or more of the claims from 1 to 8.

11. A multi-channel inverter, according to one of the claims from 9 to 10 **characterized in that** it is a photovoltaic inverter.

**Patentansprüche**

1. Verfahren (1) zum Erkennen einer Eingangskanalkonfiguration eines Mehrkanal-Wechselrichters (100) mit einer Vielzahl von Eingangskanälen ($CH_1$, $CH_2$, $CH_{i-1}$, $CH_i$, $CH_{N-1}$, $CH_N$), wobei jeder Eingangskanal mit einem entsprechenden Stromrichter ($C_1$, $C_2$, $C_{i-1}$, $C_i$, $C_{N-1}$, $C_N$) elektrisch verbunden ist, und wobei nach einer betriebsfähigen Installation des Mehrkanal-Wechselrichters, der mit einer elektrischen Gleichstromquelle ($S_1$, $S_2$, $S_{i-1}$, $S_i$, $S_{N-1}$, $S_N$) und mit einem elektrischen Wechselstromsystem (300) elektrisch verbindbar ist, die Eingangskanalkonfiguration indikativ für den physischen Verbindungsstatus der Eingangskanäle, wie z. B. unabhängig oder parallel, ist,
**dadurch gekennzeichnet, dass** das Verfahren die folgenden Schritte umfasst:

    a) Auswählen eines Referenz-Eingangskanals unter den genannten Eingangskanälen;
    b) Steuern der Stromrichter, so dass ein Eingangsstrom, der höher als ein aktueller Schwellenwert ist, entlang des Referenz-Eingangskanals festgelegt wird, und dass Eingangsströme, die niedriger als der aktuelle Schwellenwert sind, entlang eines oder mehrerer verbleibender Eingangskanäle, die sich von dem Referenz-Eingangskanal unterscheiden, festgelegt werden;
    c) Erfassen von Erkennungsdaten (D), die indikativ für Eingangsspannungen ($V_1$, $V_2$, $V_{i-1}$, $V_i$,

$V_{N-1}$, $V_N$) der Eingangskanäle sind, die einer selektiven Stromeinspeisung der Eingangskanäle folgen, die durch Steuern der Stromrichter in der Weise erhalten wird, dass die Eingangskanäle mit Strömen gespeist werden, die ausgewählte Profile oder unterschiedliche Wachstumsraten aufweisen;
    d) Durchführen eines Vergleichs zwischen den Eingangsspannungen der Eingangskanäle basierend auf den Erkennungsdaten, wobei der Vergleich das Berechnen der Spannungsdifferenzen zwischen den Eingangsspannungen der verbleibenden Eingangskanäle und der Eingangsspannung des Referenzkanals und das Vergleichen der Spannungsdifferenzen mit vordefinierten Schwellenwerten umfasst;
    e) Ausführen eines Bestimmungsverfahrens (DP), um einen Konfigurationsstatus der Eingangskanäle basierend auf einem Verhalten der Eingangsspannungen der verbleibenden Eingangskanäle in Bezug auf die Eingangsspannung des Referenzkanals zu bestimmen, wobei der Konfigurationsstatus jedes Eingangskanals bestimmt wird, indem überprüft wird, ob die Eingangsspannungen der verbleibenden Eingangskanäle mit der Eingangsspannung des Referenz-Eingangskanals abnehmen.

2. Verfahren gemäß Anspruch 1, **dadurch gekennzeichnet, dass** der Schritt b) des Steuerns der Stromrichter das Aktivieren des Stromrichters umfasst, der dem Referenz-Eingangskanal entspricht, und das Deaktivieren der Stromrichter, die den verbleibenden Eingangskanälen entsprechen, oder das Aufrechterhalten der Deaktivierung.

3. Verfahren gemäß einem oder mehreren der vorhergehenden Ansprüche, **dadurch gekennzeichnet, dass** der Schritt d) des Durchführens eines Vergleichs zwischen den Eingangsspannungen der Eingangskanäle das Überprüfen umfasst, ob sich die Eingangsspannungen der verbleibenden Eingangskanäle wie die Eingangsspannung des Referenz-Eingangskanals verhalten.

4. Verfahren gemäß Anspruch 3, **dadurch gekennzeichnet, dass** das Bestimmungsverfahren (DP) den folgenden Schritt umfasst:
e.1) falls die Eingangsspannungen der verbleibenden Eingangskanäle nicht wie die Eingangsspannung am Referenz-Eingangskanal abnehmen, Bestimmen, dass der Referenz-Eingangskanal ein unabhängiger Eingangskanal ist.

5. Verfahren gemäß Anspruch 4, **dadurch gekennzeichnet, dass** das Bestimmungsverfahren ferner die folgenden Schritte umfasst:

e.2) falls ein einziger verbleibender Eingangskanal vorhanden ist, Bestimmen, dass der verbleibende Eingangskanal ein unabhängiger Eingangskanal ist; oder
e.3) falls es eine Vielzahl von verbleibenden Eingangskanälen gibt, Wiederholen der Schritte a), b), c), d), e) für die verbleibenden Eingangskanäle.

6. Verfahren gemäß Anspruch 3, **dadurch gekennzeichnet, dass** das Bestimmungsverfahren (DP) den folgenden Schritt umfasst:
e.4) falls die Eingangsspannungen eines oder mehrerer erster verbleibender Eingangskanäle mit der Eingangsspannung an dem Referenz-Eingangskanal abnehmen, Bestimmen, dass der Referenz-Eingangskanal und der eine oder die mehreren ersten verbleibenden Eingangskanäle parallele Eingangskanäle sind.

7. Verfahren gemäß Anspruch 6, **dadurch gekennzeichnet, dass**, falls die Eingangsspannungen eines oder mehrerer zweiter verbleibender Eingangskanäle, die sich von den ersten verbleibenden Eingangskanälen unterscheiden, nicht wie die Eingangsspannung des Referenz-Eingangskanals abnehmen, das Bestimmungsverfahren (DP) die folgenden Schritte umfasst:

e.5) falls die zweiten verbleibenden Kanäle einen einzigen zweiten verbleibenden Eingangskanal aufweisen, Bestimmen, dass der verbleibende Eingangskanal ein unabhängiger Eingangskanal ist; oder
e.6) falls die zweiten verbleibenden Kanäle eine Vielzahl von zweiten verbleibenden Eingangskanälen aufweisen, Wiederholen der Schritte a), b), c), d), e) für die zweiten verbleibenden Eingangskanäle.

8. Verfahren gemäß einem oder mehreren der vorhergehenden Ansprüche, **dadurch gekennzeichnet, dass** es den Schritt f) des Speicherns von Konfigurationsinformationen (I) umfasst, die indikativ für den Konfigurationsstatus sind, der für die genannten Eingangskanäle bestimmt wurde.

9. Mehrkanal-Wechselrichter (100), der einen Eingangsabschnitt (110) umfasst, der im Betrieb so ausgebildet ist, dass er elektrisch mit einem elektrischen Gleichstromsystem (200) verbunden ist, das so ausgelegt ist, dass es am Ausgang elektrischen Gleichstrom liefert,

wobei der Eingangsabschnitt (110) eine Vielzahl von Eingangskanälen (CH$_1$, CH$_2$, CH$_{i-1}$, CH$_i$, CH$_{N-1}$, CH$_N$) umfasst, von denen jeder elektrisch mit einem entsprechenden Stromrichter

(C$_1$, C$_2$, C$_{i-1}$, C$_i$, C$_{N-1}$, C$_N$) verbunden ist und dazu ausgebildet ist, mit einer elektrischen Gleichstromquelle (S$_1$, S$_2$, S$_{i-1}$, S$_i$, S$_{N-1}$, S$_N$) elektrisch verbunden zu werden, die ferner einen Ausgangsabschnitt (120) umfassen, der im Betrieb dazu ausgebildet ist, elektrisch mit einem elektrischen Wechselstromsystem (300) verbunden zu werden, wenn der Wechselrichter (100) auf einem Feld installiert wird, so dass die Inbetriebnahmezeit und die Kosten gesenkt werden können,
**dadurch gekennzeichnet, dass** der Mehrkanal-Wechselrichter (100) Datenverarbeitungsressourcen (160) umfasst, die dazu ausgebildet sind, ein Verfahren (1) gemäß einem oder mehreren der vorhergehenden Ansprüche auszuführen.

10. Mehrkanal-Wechselrichter gemäß Anspruch 9, **dadurch gekennzeichnet, dass** er Steuereinrichtungen (140) umfasst, um die Operation des photovoltaischen Wechselrichters zu steuern, wobei die Steuereinrichtungen Datenverarbeitungsressourcen (160) umfassen, die ausgebildet sind, um ein Verfahren (1) gemäß einem oder mehreren der Ansprüche 1 bis 8 auszuführen.

11. Mehrkanal-Wechselrichter gemäß einem der Ansprüche 9 bis 10, **dadurch gekennzeichnet, dass** er ein Photovoltaik-Wechselrichter ist.

## Revendications

1. Procédé (1) pour détecter une configuration de canaux d'entrée d'un inverseur multicanal (100) possédant une pluralité de canaux d'entrée (CH$_1$, CH$_2$, CH$_{i-1}$, CH$_i$, CH$_{N-1}$, CH$_N$), chaque canal d'entrée étant relié électriquement à un convertisseur de puissance correspondant (C$_1$, C$_2$, C$_{i-i}$, C$_i$, C$_{N-1}$, C$_N$) et, lors d'une installation opérationnelle dudit inverseur multicanal, pouvant être relié électriquement à une source d'alimentation électrique CC (S$_1$, S$_2$, S$_{i-1}$, S$_i$, S$_{N-1}$, S$_N$) et à un système électrique CA (300), la configuration de canaux d'entrée indiquant l'état de connexion physique des canaux d'entrée, par exemple un état indépendant ou parallèle,
**caractérisé en ce qu'**il comprend les étapes suivantes consistant à :

a) sélectionner un canal d'entrée de référence parmi lesdits canaux d'entrée ;
b) commander lesdits convertisseurs de puissance de telle façon qu'un courant d'entrée supérieur à un seuil de courant soit établi le long dudit canal d'entrée de référence et de telle façon que des courants d'entrée inférieurs audit seuil de courant soient établis le long d'un ou plusieurs canaux d'entrée restants, autres que ledit canal d'entrée de référence ;

c) acquérir des données de détection (D) indiquant les tensions d'entrée ($V_1$, $V_2$, $V_{i-1}$, $V_i$, $V_{N-1}$, $V_N$) desdits canaux d'entrée qui suivent l'introduction sélective de courant dans lesdits canaux d'entrée obtenue en commandant lesdits convertisseurs de puissance de telle manière que lesdits canaux d'entrée soient alimentés par des courants ayant des profils sélectionnés ou des vitesses de croissance différentes ;

d) effectuer une comparaison entre les tensions d'entrée desdits canaux d'entrée d'après lesdites données de détection, ladite comparaison comprenant le calcul de différences de tension entre les tensions d'entrée desdits canaux d'entrée restants et la tension d'entrée dudit canal de référence, et la comparaison desdites différences de tension aux valeurs de seuil prédéfinies ;

e) exécuter une procédure de détermination (DP) pour déterminer un état de configuration desdits canaux d'entrée d'après un comportement des tensions d'entrée desdits canaux d'entrée restants par rapport à la tension d'entrée dudit canal de référence, l'état de configuration de chaque canal d'entrée étant déterminé en vérifiant si les tensions d'entrée desdits canaux d'entrée restants diminuent comme la tension d'entrée dudit canal d'entrée de référence.

2. Procédé selon la revendication 1, **caractérisé en ce que** ladite étape b) de commande desdits convertisseurs de puissance comprend l'activation du convertisseur de puissance correspondant audit canal d'entrée de référence et la désactivation ou le maintien à l'état désactivé des convertisseurs de puissance correspondant auxdits canaux d'entrée restants.

3. Procédé selon une ou plusieurs des revendications précédentes, **caractérisé en ce que** ladite étape d) d'exécution d'une comparaison entre les tensions d'entrée desdits canaux d'entrée comprend la vérification du fait que les tensions d'entrée desdits canaux d'entrée restants se comportent ou non comme la tension d'entrée dudit canal d'entrée de référence.

4. Procédé selon la revendication 3, **caractérisé en ce que** ladite procédure de détermination (DP) comprend l'étape suivante consistant à :
e.1) si les tensions d'entrée desdits canaux d'entrée restants ne diminuent pas comme la tension d'entrée présente au niveau dudit canal d'entrée de référence, déterminer que ledit canal d'entrée de référence est un canal d'entrée indépendant.

5. Procédé selon la revendication 4, **caractérisé en ce**

que ladite procédure de détermination comprend également les étapes suivantes consistant à :

e.2) s'il n'existe qu'un seul canal d'entrée restant, déterminer que ledit canal d'entrée restant est un canal d'entrée indépendant ; ou
e.3) s'il existe une pluralité de canaux d'entrée restants, répéter lesdites étapes a), b), c), d), e) pour lesdits canaux d'entrée restants.

6. Procédé selon la revendication 3, **caractérisé en ce que** ladite procédure de détermination (DP) comprend l'étape suivante consistant à :
e.4) si les tensions d'entrée d'un ou plusieurs premiers canaux d'entrée restants diminuent comme la tension d'entrée présente au niveau dudit canal d'entrée de référence, déterminer que ledit canal d'entrée de référence et lesdits un ou plusieurs premiers canaux d'entrée restants sont des canaux d'entrée parallèles.

7. Procédé selon la revendication 6, **caractérisé en ce que** si les tensions d'entrée d'un ou plusieurs deuxièmes canaux d'entrée restants, différents desdits premiers canaux d'entrée restants, ne diminuent pas comme la tension d'entrée dudit canal d'entrée de référence, ladite procédure de détermination (DP) comprend les étapes suivantes consistant à :

e.5) si lesdits deuxièmes canaux d'entrée restants ne contiennent qu'un seul deuxième canal d'entrée restant, déterminer que ledit canal d'entrée restant est un canal d'entrée indépendant ; ou
e.6) si lesdits deuxièmes canaux d'entrée restants contiennent une pluralité de deuxièmes canaux d'entrée restants, répéter lesdites étapes a), b), c), d), e) pour lesdits deuxièmes canaux d'entrée restants.

8. Procédé selon une ou plusieurs des revendications précédentes, **caractérisé en ce qu'**il comprend l'étape f) de stockage d'informations de configuration (I) indiquant l'état de configuration déterminé pour lesdits canaux d'entrée.

9. Inverseur multicanal (100) comprenant une section d'entrée (110) qui, en fonctionnement, est configurée pour être reliée électriquement à un système électrique CC (200) conçu pour fournir une alimentation électrique CC en sortie, la section d'entrée (110) comprenant une pluralité de canaux d'entrée ($CH_1$, $CH_2$, $CH_{i-1}$, $CH_i$, $CH_{N-1}$, $CH_N$), chacun d'eux étant relié électriquement à un convertisseur de puissance correspondant ($C_1$, $C_2$, $Ci-i$, $C_i$, $C_{N-1}$, $C_N$) et configuré pour être relié électriquement à une source d'alimentation électrique CC ($S_1$, $S_2$, $Si-i$, $S_i$, $S_{N-1}$, $S_N$), comprenant également une section de sortie (120) qui, en fonctionnement, est configurée pour être reliée électriquement à un système électrique CA (300) lorsque l'inverseur (100) est installé sur un terrain, de façon à pouvoir abaisser les durées et les coûts de mise en service, l'inverseur multicanal (100) étant **caractérisé en ce qu'**il comprend des ressources de traitement de données (160) configurées pour exécuter un procédé (1) selon une ou plusieurs des revendications précédentes.

10. Inverseur multicanal selon la revendication 9, **caractérisé en ce qu'**il comprend un moyen de commande (140) permettant de commander le fonctionnement dudit inverseur photovoltaïque, ledit moyen de commande comprenant des ressources de traitement de données (160) configurées pour exécuter un procédé (1) selon une ou plusieurs des revendications 1 à 8.

11. Inverseur multicanal selon une des revendications 9 et 10, **caractérisé en ce qu'**il consiste en un inverseur photovoltaïque.

FIG. 1

FIG. 2

EP 3 509 205 B1

**FIG. 3A**

start

DP

voltage decrease at the reference input channel only?

YES → the reference input channel is an independent channel (e.1)

is there a single remaining input channel?

YES → the single remaining input channel is an independent channel (e.2)

stop

NO → repeat steps a) to e) for the remaining input channels (e.3)

NO → first remaining input channels with voltage decrease?

YES → the reference input channel and the first remaining input channels are parallel input channels (e.4)

NO → continue

18

DP

continue

second remaining
input channels
with no voltage
decrease?

NO → stop

YES

is there a single
second remaining
input channel?

YES → the single second remaining
input channel is an
independent channel

e.5)

NO

repeat steps a) to e)
for said secondary input
channels

e.6)

**FIG. 3B**

FIG. 4

EP 3 509 205 B1

**FIG. 5**

**FIG. 6**

**FIG. 7**

FIG. 8

**FIG. 9**

FIG. 10

**REFERENCES CITED IN THE DESCRIPTION**

**Patent documents cited in the description**

- US 2015076911 A

- US 2011204878 A